# DEMANDE DE BREVET EUROPEEN

(11) **EP 2 187 401 A1**
(43) Date de publication de la demande: **19.05.2010**
(21) Numéro de dépôt: 09175600.7
(22) Date de dépôt: 10.11.2009
(51) Int. Cl.: G11C 13/02

(54) **Procédé d'élaboration d'une couche à stockage de charges d'une cellule de mémoire**

(30) Priorité: 14.11.2008 FR 0857737
(71) Demandeur: Commissariat à l'énergie atomique et aux énergies alternatives, 75015 Paris (FR)
(72) Inventeur: Ivanova-Hristova, Valentina, 38000 Grenoble (FR); De Salvo, Barbara, 38330 Montbonnot Saint Martin (FR)
(74) Mandataire: Ilgart, Jean-Christophe

(57) **Abrégé**

L'invention a trait à un procédé d'élaboration d'une couche à stockage de charges comprenant des particules métalliques d'une cellule de mémoire, ladite couche consistant en une couche organique comprenant, en surface, lesdites particules métalliques, ledit procédé comprenant les étapes suivantes :
- une étape de greffage d'un substrat métallique, semi-conducteur ou électriquement isolant par une couche organique comprenant en surface des groupes aptes à complexer au moins un élément métallique sous forme cationique ;
- une étape de mise en contact de ladite couche avec une solution comprenant ledit élément métallique sous forme cationique, moyennant quoi ledit élément métallique est complexé par lesdits groupes susmentionnés ; et
- une étape de réduction dudit élément métallique complexé en élément métallique à l'état d'oxydation 0, moyennant quoi l'on obtient des particules métalliques.

Application au domaine des cellules de mémoire.

## Description

### DOMAINE TECHNIQUE

L'invention a trait à un procédé d'élaboration d'une couche à stockage de charges destinée à une cellule de mémoire, cette couche consistant en une couche organique comprenant, à sa surface, des particules métalliques.

En particulier, ce procédé peut trouver son application dans la conception de dispositifs mémoires de type capacitif ou de dispositifs mémoires de type résistif.

Ainsi, le domaine général de l'invention est celui des dispositifs mémoires.

### ÉTAT DE LA TECHNIQUE ANTÉRIEURE

Les dispositifs mémoires sont constitués d'éléments de base, les cellules mémoires destinées à stocker les données. Plusieurs types de mémoires existent :
- les mémoires vives, également appelées mémoires RAM (correspondant à la terminologie anglaise « Random Access Memory » signifiant « Mémoire à accès aléatoire »), qui sont des mémoires dites volatiles, car les données contenues en elles sont perdues après quelques secondes, lorsque l'alimentation électrique est coupée et dans lesquelles les données peuvent être écrites, lues ou réécrites autant de fois que nécessaire ;
- les mémoires mortes, également appelées mémoires ROM (correspondant à la terminologie anglaise « Read-on memory » signifiant « Mémoire à lecture seule »), sont des mémoires programmées par le fabricant et dites non volatiles, car elles conservent les données qui y sont contenues en absence de tension d'alimentation et dans lesquelles les données sont accessibles seulement en lecture ;
- les mémoires Flash combinant à la fois les avantages des mémoires vives (en termes d'écriture, lecture et effacement de blocs en données) et ceux des mémoires mortes (en termes de permanence du contenu même hors tension), la dénomination Flash provenant du fait que les opérations d'effacement des mémoires sont très rapides, en raison du fait que ces mémoires sont effaçables par secteur complet, et non par cellule individuelle.

A l'heure actuelle, les mémoires Flash, en raison notamment de leur caractère de rétention (qui peut être de l'ordre de 10 ans) et de leur capacité d'intégration, font l'objet de nombreux développements, notamment du fait de leurs applications dans les systèmes électroniques modernes, tels que les ordinateurs portables, les téléphones cellulaires, les caméras digitales, les cartes mémoires Flash, les systèmes de localisation GPS.

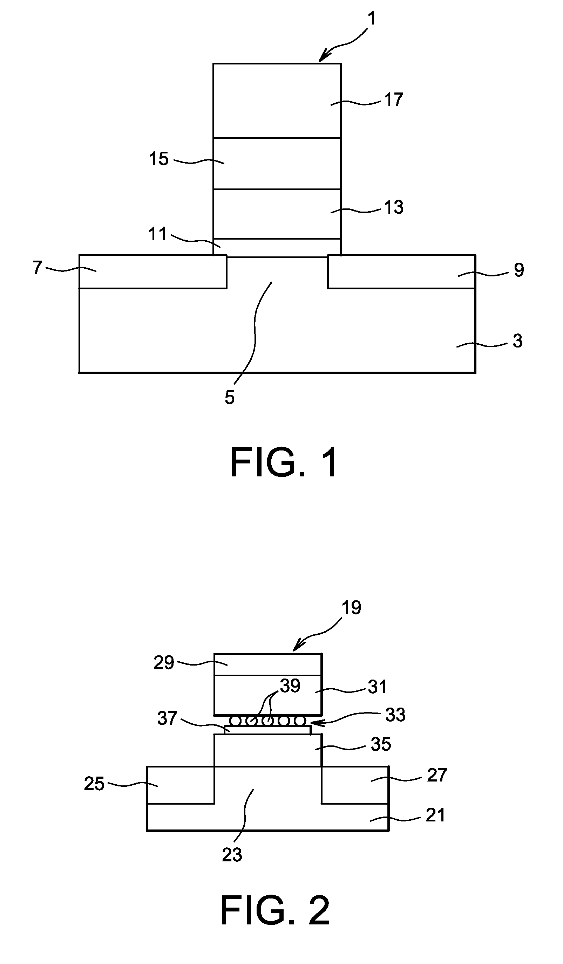

La structure d'une cellule élémentaire d'une mémoire Flash d'un transistor à effet de champ est représentée sur la figure 1 annexée.

Un tel transistor 1 comprend respectivement un substrat 3, un canal 5, une source 7, un drain 9 et sur le canal, respectivement un diélectrique tunnel 11, une grille flottante 13, un diélectrique de contrôle 15 et une grille de contrôle 17. La grille flottante désigne une grille isolée électriquement ayant une fonction de stockage de charges, soit en d'autres termes, un élément de stockage de l'information. Cette grille flottante se présente classiquement sous forme d'une couche continue en un matériau tel que du silicium polycristallin dopé n. On parle ainsi de grille flottante continue.

A l'heure actuelle, la volonté est d'augmenter la capacité de stockage des dispositifs de mémoire tout en allant vers une miniaturisation des cellules élémentaires les constituant. Pour ce faire, de nouvelles architectures et de nouveaux matériaux font aujourd'hui l'objet d'études.

Ainsi, une solution peut consister à conserver l'architecture d'une cellule de mémoire Flash classique telle que définie ci-dessus, mais en modifiant la structure de la grille flottante. Il a été ainsi proposé d'incorporer, dans ces cellules, des sites de piégeage discrets en tant que grille flottante. Les sites de piégeage discrets présentent l'avantage de pouvoir être isolés électriquement entre eux. Ainsi, la présence d'un défaut dans le diélectrique tunnel, qui entraîne une décharge complète dans le cas du dispositif à grille flottante continue, n'affectera que la charge située à proximité du défaut. Cette nouvelle architecture faisant intervenir des sites de piégeage discrets peut permettre ainsi de diminuer l'épaisseur du diélectrique tunnel et, par conséquent, de diminuer les potentiels nécessaires au fonctionnement de la mémoire, en conservant de bonnes caractéristiques de rétention et d'endurance. On peut citer comme sites de piégeage discrets particulièrement intéressants des îlots métalliques présentant une taille nanométrique agissant en tant que sites de stockage incorporés dans une matrice isolante.

Une telle cellule de mémoire est décrite par les auteurs Takata et al, dans l'article « New Non-Volatile Memory with Extremely High Density Metal Nano-Dots », 0-7803-7873-3/03/$17.00(c)2003 IEEE. Cette cellule de mémoire comprend une grille flottante sous forme de particules métalliques de taille nanométrique enrobées par du SiO₂.

Cette grille flottante est obtenue par pulvérisation cathodique (correspondant au terme anglais « sputtering ») d'une cible comprenant à la fois du SiO₂ et les particules métalliques, en l'occurrence ici du cobalt.

De tels films à stockage de charge obtenus par cette technique présentent les inconvénients suivants :
- l'absence de distribution uniforme des tailles des nanoparticules métalliques au sein de la couche, du fait de l'impossibilité de contrôler la répartition en taille de celles-ci par la technique de pulvérisation cathodique ;
- l'absence de localisation précise et d'uniformité et ordre dans la répartition spatiale des particules dans la couche de stockage, la distribution se faisant dans toute l'épaisseur de celle-ci.

Il existe ainsi un véritable besoin pour une nouvelle architecture de film (ou couche) à stockage de charge ainsi qu'à un procédé de fabrication de celle-ci permettant de surmonter les inconvénients de l'art antérieur.

### EXPOSÉ DE L'INVENTION

Les auteurs de l'invention ont mis au point une nouvelle architecture et un procédé d'élaboration d'une couche à stockage de charges d'une cellule de mémoire, qui permettrait de résoudre les inconvénients de l'art antérieur, notamment les problèmes d'uniformité, en termes de taille et position spatiale des sites de piégeage.

Ainsi, l'invention a trait, selon un premier objet, à un procédé d'élaboration d'une couche à stockage de charges comprenant des particules métalliques d'une cellule de mémoire, ladite couche consistant en une couche organique comprenant, en surface, lesdites particules métalliques, ledit procédé comprenant les étapes suivantes :
- une étape de greffage d'un substrat métallique, semi-conducteur ou électriquement isolant par une couche organique comprenant en surface des groupes aptes à complexer au moins un élément métallique sous forme cationique ;
- une étape de mise en contact de ladite couche avec une solution comprenant ledit élément métallique sous forme cationique, moyennant quoi ledit élément métallique est complexé par lesdits groupes susmentionnés ; et
- une étape de réduction dudit élément métallique complexé en élément métallique à l'état d'oxydation 0, moyennant quoi l'on obtient les particules métalliques.

Avant d'entrer plus en détail dans la description, nous proposons les définitions suivantes.

Par greffage, on entend, classiquement, au sens de l'invention, une immobilisation de ladite couche susmentionnée sur le substrat susmentionné par le biais d'une liaison chimique covalente, la formation d'une liaison covalente étant rendue possible par un choix approprié des composés susceptibles d'entrer dans la constitution de ladite couche, ces composés comprenant un groupe chimique apte à réagir avec un groupe présent à la surface du substrat, de sorte à former une liaison covalente.

Par groupe apte à complexer au moins un élément métallique, on entend un groupe chimique apte à fixer ledit élément métallique par liaison de coordination.

De ce nouveau procédé mis en oeuvre découlent les avantages suivants :
- la possibilité de contrôler la quantité de particules métalliques dans la couche, en optimisant, lors de la première étape, la quantité de groupes aptes à complexer l'élément métallique sous forme cationique ;
- la possibilité de contrôler l'uniformité desdites particules dans la couche, toujours en optimisant le greffage de la couche organique ;
- la possibilité de contrôler la taille des particules métalliques en optimisant le temps de complexation des cations.

Les particules métalliques sont classiquement des particules nanométriques, à savoir des particules présentant une taille moyenne de particules allant de 3 à 10 nm, ces particules pouvant être en un métal choisi parmi Pd, Pt, Ru, Co, Ni, W, Ti, Mo, Au, Ag.

Le substrat servant de base au greffage de la couche organique peut être un substrat électriquement isolant, tel qu'un substrat en silice SiO₂, Al₂O₃, SiN, HfO₂, HfAlO, HfSiO, La₂O₃, un substrat semi-conducteur, tel qu'un substrat en silicium Si, en germanium Ge, en alliage silicium germanium ou un substrat métallique (par exemple, une électrode en Au, Al, Cu, Ti, Pt).

La couche organique greffée est, avantageusement, une couche organique auto-assemblée.

On précise que, par couche auto-assemblée, on entend une couche, dont la cohésion est assurée par un choix approprié de composés la constituant, cette cohésion se faisant avantageusement par le biais de liaisons du type Van der Waals, dipolaires, de liaisons hydrogène, ces liaisons existant entre les chaînes de composés greffés à la surface du substrat. On peut parler ainsi de liaisons intra-chaînes.

En particulier, la couche auto-assemblée peut être une monocouche auto-assemblée (pouvant être également nommée couche SAM, (l'abréviation SAM correspond à l'expression anglaise « Self-Assembled Monolayer ») ou des multicouches auto-assemblées.

Selon l'invention, l'étape de greffage peut consister en une étape de mise en contact dudit substrat avec au moins un composé comprenant au moins un premier groupe apte à réagir avec un groupe présent en surface dudit substrat pour former une liaison covalente et au moins un second groupe apte à complexer au moins un élément métallique, ledit premier groupe et ledit second groupe étant éventuellement séparés par une chaîne hydrocarbonée comprenant un nombre d'atomes de carbone supérieur ou égal à 1.

Lors de cette mise en contact, les composés susmentionnés vont réagir par le biais du premier groupe tel que défini ci-dessus avec un groupe de la surface du substrat, tandis que les chaînes hydrocarbonées vont interagir entre elles spontanément pour former des liaisons du type Van der Waals, hydrogène, formant ainsi une couche auto-assemblée, l'épaisseur de la couche étant constituée par l'ensemble des chaînes hydrocarbonées.

En surface de ladite couche affleurent ainsi les seconds groupes tel que définis ci-dessus.

Ledit premier groupe apte à réagir avec la surface dudit substrat pour former une liaison covalente, éventuellement après hydrolyse de celui-ci, peut être un groupe choisi parmi un atome d'halogène, un groupe -OH et un groupe alcoxy.

Ledit second groupe apte à complexer un élément métallique peut être un groupe comprenant un atome porteur d'un doublet libre, tel qu'un groupe amine, thiol, -OH et/ou d'une charge négative, tel qu'un groupe carboxyle.

Le composé peut répondre à l'une des formules suivantes :

R- (CH₂)ₙ-SiX₃

dans laquelle :
- les X représentent les groupes aptes à se greffer, éventuellement après hydrolyse, à la surface du substrat, ces groupes étant choisis, indépendamment parmi les atomes d'halogène, les groupes alcoxy ;
- R est choisi parmi les groupes amine, carboxyle, thiol, -OH ;
- n est un nombre entier supérieur ou égal à 1 ;

R-X¹

dans laquelle :
- R est choisi parmi les groupes amine, carboxyle, thiol, -OH ;
- X¹ est Li, MgX², X² étant un atome d'halogène ;

R-OH dans laquelle R est choisi parmi les groupes amine, carboxyle, thiol, -OH.

Comme mentionné ci-dessus, les composés comportent des groupes aptes, après une éventuelle transformation à réagir avec des groupes présents à la surface du substrat pour former une liaison covalente.

Préalablement à la mise en contact susmentionnée, le procédé peut comprendre une étape de traitement dudit substrat, de sorte à créer à sa surface des groupes réactifs qui seront susceptibles de réagir avec les premiers groupes du composé susmentionné.

Cette étape de traitement peut consister en une hydroxylation du substrat de sorte à créer à sa surface des groupes hydroxyles. Ainsi, avec un substrat en oxyde de silicium, le traitement d'hydroxylation peut consister à soumettre le substrat à un traitement acide en présence d'eau oxygénée.

Ainsi, à titre d'exemple, l'étape de mise en contact peut consister à faire réagir un substrat en oxyde de silicium comprenant, en surface des groupes -OH avec un composé de formule R-(CH₂)ₙ-SiX₃ en milieu aqueux. En présence d'eau, les groupes X s'hydrolysent en groupe -OH pour donner le composé R-(CH₂)ₙ-Si(OH)₃. Le schéma réactionnel de formation de la couche peut être ainsi le suivant :

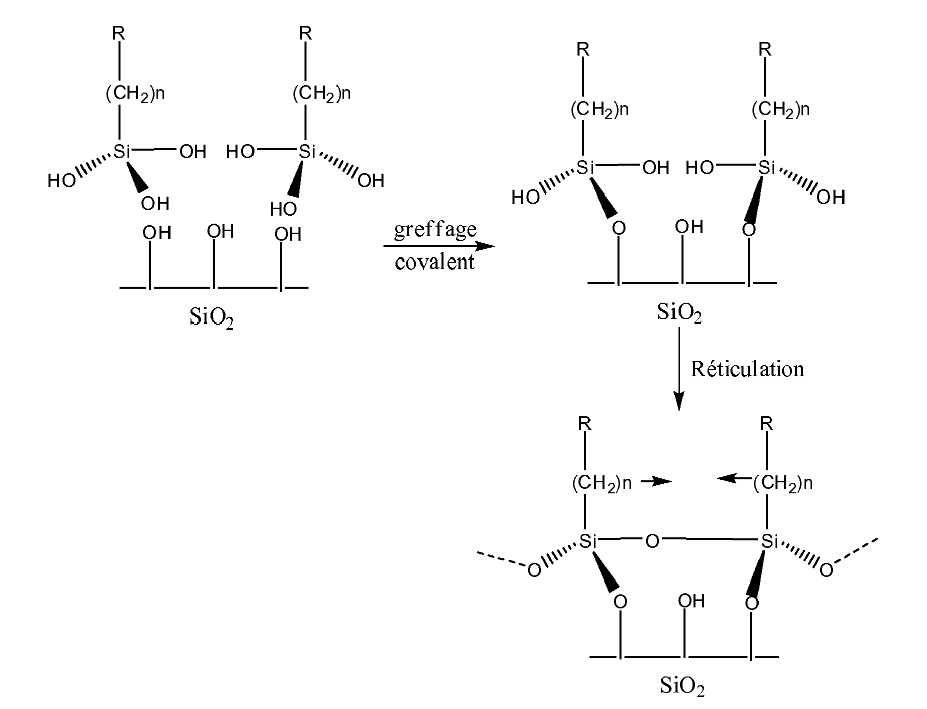

Les chaînes hydrocarbonées -(CH₂)ₙ- en vis-à-vis interagissent par le biais de liaisons du type Van der Waals pour former une couche auto-assemblée, tel que cela est indiqué par les flèches sur le schéma représenté ci-dessus.

Avec des composés du type R-X¹ et R-OH, le greffage covalent pourra être réalisé avec des substrats comportant, en surface, des groupes réactifs vis-à-vis de X¹ et de OH, à savoir qu'il peut s'agir d'atomes d'halogène (Cl, Br, I) ou d'atomes d'hydrogène.

Pour un substrat en silicium, cela peut nécessiter une étape de traitement de celui-ci pour former des liaisons C-Halogène, ces traitements pouvant être les suivants :
- pour former une liaison C-Cl, un traitement du substrat en silicium en présence de PCl₅ ou Cl₂ ;
- pour former une liaison C-Br, un traitement du substrat en silicium en présence de N-Bromosuccinimide et de CCl₃Br ;
- pour former une liaison C-I, un traitement du substrat en silicium en présence de I₂ ou CHI₃.

D'un point de vue pratique, les composés susmentionnés sont mis en contact avec le substrat sous forme d'une solution de concentration pouvant aller de 10⁻⁶ à 10⁻² M, par exemple 10⁻³ M, l'étape de mise en contact étant maintenue jusqu'à formation de la couche greffée, cette formation pouvant être visualisée par une technique appropriée (telle que la microscopie à force atomique, la microscopie électronique à balayage, la microscopie électronique à effet tunnel), la durée de mise en contact pouvant aller de 1 heure à 2 jours. Avantageusement, la solution présentera une concentration de 10⁻⁶ M pour les substrats métalliques et une concentration de 10⁻³ M pour les substrats semiconducteurs et les substrats isolants (tels que les substrats en oxyde).

La solution comprenant le composé peut être une solution comprenant ledit composé dissous dans un solvant alcane.

Une fois la couche organique greffée sur le substrat, il est procédé à une étape de mise en contact du substrat ainsi greffé avec une solution comprenant ledit élément métallique sous forme ionique, moyennant quoi ledit élément métallique est complexé par lesdits groupes susmentionnés.

Cette solution peut être une solution comprenant des cations métalliques choisis parmi les cations de platine, palladium, ruthénium, cobalt, nickel et les mélanges de ceux-ci.

La durée de mise en contact est déterminée de sorte à permettre la complexation desdits cations métalliques par les groupes appropriés de la couche organique greffée, cette durée pouvant s'échelonner de quelques secondes à une heure, par exemple 15 minutes.

Le substrat greffé par la couche organique complexée est ensuite soumis à une étape de réduction destinée à réduire les cations métalliques en métal de degré d'oxydation 0, les cations se transformant ainsi en particules métalliques.

Préalablement à l'étape de réduction, le substrat peut être amené à subir une étape de rinçage, de sorte à éliminer les éléments métalliques non complexés.

Cette réduction peut être réalisée selon plusieurs variantes.

Selon une première variante, la réduction est réalisée en appliquant au substrat immergé dans un électrolyte un potentiel d'électrode suffisant pour obtenir ladite réduction. Cette variante correspond à la technique de l'électrodéposition ou « dépôt électrolytique ».

Selon une seconde variante, la réduction est réalisée par mise en contact du substrat immergé dans un électrolyte avec un agent réducteur. Cet agent réducteur peut être le diméthylamine-borane (connu sous l'abréviation DMAB), le formaldéhyde, l'hypophosphite, le borohydrate de potassium, l'hydrazine. Cette variante correspond à la technique de « déposition autocatalytique » (correspondant à l'expression anglaise « electroless deposition »).

Que ce soit pour la première variante ou la seconde variante, l'électrolyte est classiquement une solution aqueuse acide, par exemple, une solution aqueuse d'acide sulfurique H₂SO₄ (telle qu'une solution H₂SO₄ 0,1 M), cette solution devant être libre d'ions métalliques de sorte à ce qu'il n'y ait pas d'autres réductions que celle des cations métalliques complexés sur la couche organique.

Une fois la réduction réalisée, les atomes métalliques peuvent spontanément subir un phénomène de coalescence et former ainsi des îlots métalliques.

A l'issue de l'étape de réduction, les atomes métalliques peuvent former des îlots monoatomiques en hauteur présentant une taille latérale pouvant aller de 4 à 6 nm, qui sont dispersés de façon uniforme au sommet de la couche organique, pour une densité pouvant aller de 10¹¹ îlots/cm² à 10¹³ îlots/cm². La densité et la taille des îlots peuvent être déterminées par microscopie AFM, STM ou TEM.

Les particules métalliques ainsi obtenues peuvent servir dans des dispositifs électroniques de sites de piégeage discrets, tandis que la couche organique sous-jacente assurera le rôle de diélectrique.

Selon les applications envisagées, afin notamment d'augmenter la taille des îlots métalliques, le procédé de l'invention peut comprendre, après l'étape de réduction, une étape de dépôt, sur la couche organique comprenant, en surface, des particules métalliques, d'au moins une deuxième couche métallique. Cette deuxième couche métallique peut être déposée par une technique électrochimique de dépôt. Dans ce cas, les particules métalliques obtenues précédemment peuvent remplir le rôle de sites de nucléation pour le dépôt de la couche métallique. Dans le cas d'un dépôt autocatalytique, les particules métalliques déposées préalablement peuvent remplir le rôle de catalyseur. A titre d'exemple, lorsque les particules métalliques sont en palladium, elles peuvent ainsi jouer un rôle de catalyseur de réduction du second élément métallique destiné, après achèvement de la réduction, à constituer la couche métallique.

L'invention a trait selon un second objet à une couche à stockage de charges surmontant un substrat métallique, semi-conducteur ou électriquement isolant d'une cellule de mémoire susceptible d'être obtenu par le procédé susmentionné, ladite couche consistant en une couche organique greffée sur ledit substrat et comprenant, à sa surface, des particules métalliques.

Les caractéristiques de particules métalliques et de substrat sont identiques à celles déjà mentionnées ci-dessus dans le cadre de la description du procédé.

Quant à la couche organique, elle peut être issue de composés tels que définis ci-dessus.

Une telle couche de stockage est destinée à être incorporée dans des cellules de mémoire destinées à entrer dans la constitution de dispositifs qui peuvent être de plusieurs types :
- des dispositifs mémoires de type capacitif, correspondant à un transistor à effet de champ dans lesquels la couche à stockage de charges constituera un des éléments du transistor, cette couche pouvant remplir notamment le rôle de grille flottante ;
- des dispositifs mémoires de type résistif, correspondant à une cellule mémoire, dans lesquels la couche à stockage de charges telle que définie ci-dessus peut être disposée entre deux électrodes.

Ainsi, l'invention a trait à une cellule de mémoire comprenant au moins une couche à stockage de charges surmontant un substrat métallique, semi-conducteur ou électriquement isolant telle que définie ci-dessus, cette cellule de mémoire pouvant être une cellule mémoire de type capacitive ou résistive.

En particulier, la cellule de mémoire de l'invention peut être un transistor à effet de champ pouvant comprendre au moins une couche de stockage de charges telle que définie précédemment.

Le transistor à effet de champ peut adopter différentes configurations comme représentées sur les figures 2, 3, 4 et 5.

Ainsi, selon une première configuration, comprenant, telle que représentée sur la figure 2, le transistor à effet de champ 19 comprend :
- un substrat 21 comportant un canal 23 ;
- une source 25 et un drain 27 disposés de part et d'autre du canal et en contact électrique avec celui-ci ;
- une grille de contrôle 29 disposée au-dessus du canal et séparée de celui-ci par un diélectrique de contrôle 31 et une grille flottante 33 et un diélectrique tunnel 35, la grille flottante 33 consistant en la couche de stockage de charges telle que mentionnée ci-dessus, cette grille flottante se subdivisant en deux parties : la couche organique 37 et au sommet de ladite couche des particules métalliques 39, réalisée par une ou plusieurs étapes de dépôt.

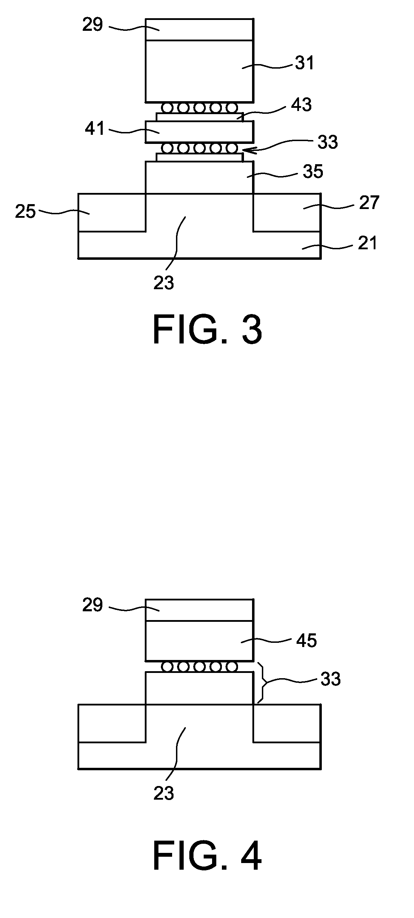

Selon une deuxième configuration, variante de la première, telle que représentée sur la figure 3, le transistor à effet de champ comprend, en sus des différentes parties du transistor à effet de champ de la première configuration, une couche de diélectrique 41 surmontée d'une deuxième couche à stockage de charges conforme à l'invention 43 conforme à l'invention, cette succession de deux couches étant disposée entre le diélectrique de contrôle 31 et la première couche à stockage de charges 33.

De la même manière, une autre configuration peut comprendre n grilles flottantes (n étant un nombre entier supérieur ou égal à 1) séparées par des couches diélectriques.

Selon ces deux configurations, la grille de contrôle peut être en silicium polycristallin ou en un métal tel que Pt, W ou en un nitrure tel que TaN, WN, TiN.

Selon une troisième configuration, telle que représentée sur la figure 4, le transistor à effet de champ comprend entre la grille de contrôle 29 et le canal 23, respectivement une couche à stockage de charges 33 conforme à l'invention déposée sur le canal et une couche organique 45 isolante, par exemple identique à celle constituant les couches à stockage de charges de l'invention interposée entre la grille de contrôle 29 et la couche à stockage de charges 33.

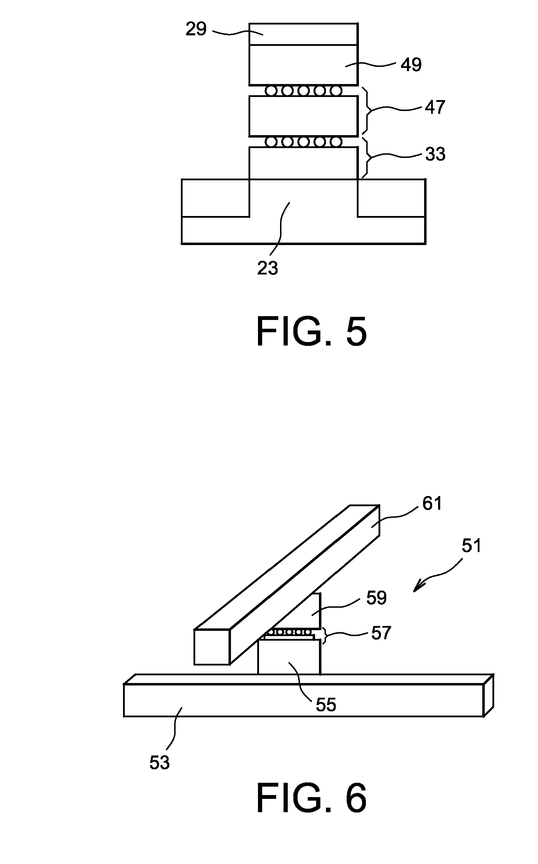

Selon une quatrième configuration, telle que représentée sur la figure 5, le transistor à effet de champ comprend entre la grille de contrôle 29 et le canal 23, respectivement une première couche à stockage de charges 33 déposée sur le canal, une deuxième couche à stockage de charges 47 déposées sur ladite première couche à stockage de charges 33 et une couche organique 49 isolante, par exemple identique à celle constituant les couches à stockage de charges de l'invention interposée entre la grille de contrôle 29 et ladite deuxième couche à stockage de charges 47.

De la même manière, une autre configuration peut comprendre « n » couches de stockage de charge (avec n étant un nombre entier supérieur ou égal à 1) séparées par des couches organiques.

Les différentes parties de ces dispositifs (canal, source, drain, diélectrique tunnel, diélectrique de contrôle) sont réalisées par des techniques classiques adaptées aux particules métalliques connues de l'homme du métier, tandis que la (les) couches à stockage de charges conformes à l'invention est (sont) réalisée(s) par un procédé conforme à l'invention.

La grille de contrôle peut se réaliser par des techniques classiques ou de manière similaire à la couche de stockage, en faisant plusieurs complexations et en ajustant le temps de complexation afin d'obtenir une couche métallique continue.

Comme mentionné ci-dessus, l'invention peut aussi avoir trait à une cellule résistive de mémoire comprenant au moins une couche à stockage de charges conforme à l'invention, notamment un dispositif de type résistif, qui pourrait, par exemple, être inclus dans une architecture de matrice mémoire dite « crossbar ».

Un tel dispositif peut adopter différentes configurations, comme représentées sur les figures 6 à 9.

Ainsi, selon une première configuration, telle que représentée sur la figure 6, la cellule résistive de mémoire 51 comprend :
- une électrode inférieure 53, par exemple une électrode métallique (telle qu'une électrode en Al, Au, Ti ou Cu), une électrode en nitrure (telle qu'une électrode en TiN, TaN) ou une électrode en matériau semi-conducteur (telle qu'une électrode en Si, Ge, SiGe) ;
- un premier diélectrique solide 55 déposée sur ladite électrode inférieure ;
- une couche à stockage de charges 57 déposée sur le premier diélectrique ;
- un second diélectrique solide 59 déposée sur ladite couche à stockage de charges 57;
- une électrode supérieure 61 métallique ou semi-conductrice disposée sur ledit second diélectrique 59.

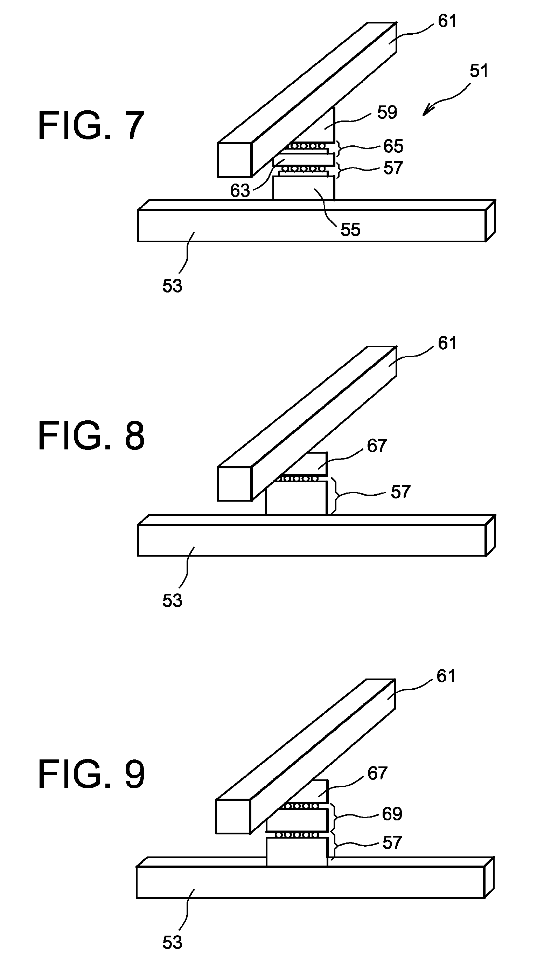

Selon une deuxième configuration, telle que représentée sur la figure 7, la cellule résistive de mémoire comprend, en sus des différentes parties de celle de la première configuration, une couche de diélectrique 63 surmontée d'une deuxième couche à stockage de charges 65 conforme à l'invention, cette succession de deux couches étant disposée entre la première couche à stockage de charge 57 et le second diélectrique 59.

Selon une troisième configuration, telle que représentée sur la figure 8, la cellule résistive de mémoire comprend, entre l'électrode inférieure 53 et l'électrode supérieure 61, respectivement une couche à stockage de charges 57 conforme à l'invention déposée sur l'électrode inférieure et une couche organique 67 isolante, par exemple identique à celle constituant les couches à stockage de charges de l'invention interposée entre la couche à stockage de charges 57 et l'électrode supérieure 61.

Enfin, selon une quatrième configuration, telle que représentée sur la figure 9, la cellule résistive de mémoire comprend entre l'électrode inférieure 53 et l'électrode supérieure 61, respectivement une première couche à stockage de charges 57 déposée sur l'électrode inférieure 53, une deuxième couche à stockage de charges 69 déposée sur ladite première couche à stockage de charges 57 et une couche organique 67 isolante, par exemple identique à celle constituant les couches à stockage de charges de l'invention interposée entre l'électrode inférieure et l'électrode supérieure.

De la même manière, une autre configuration peut comprendre n couches de stockage (n étant un nombre entier supérieur ou égal à 1) séparées par des couches organiques.

L'électrode supérieure peut être réalisée par des techniques classiques ou, de manière similaire à la couche de stockage, en faisant plusieurs étapes de complexation et en ajustant le temps de complexation, afin d'obtenir une couche métallique continue.

L'invention va maintenant être décrite par rapport aux exemples suivants donnés à titre illustratif et non limitatif.

### BRÈVE DESCRIPTION DES DESSINS

La figure 1 est un vue en coupe d'une cellule de mémoire classique du type « transistor à effet de champ ».
Les figures 2 à 5 représentent différentes configurations d'un transistor à effet de champ comprenant au moins une couche à stockage de charges conforme à l'invention.
Les figures 6 à 9 représentent différentes configurations d'une cellule résistive de mémoire comprenant au moins une couche à stockage de charges conforme à l'invention.

### EXPOSÉ DÉTAILLÉ DE MODES DE RÉALISATION PARTICULIERS

L'exemple ci-dessous illustre la préparation conformément à l'invention d'une couche de stockage sur un substrat en or.

### EXEMPLE

Dans un premier temps, une électrode en or Au (111) est immergée pendant 5 minutes sans contrôle de potentiel dans une solution aqueuse comprenant du 4,4'-dithiopyridine (symbolisé 4-PySSPy, Aldrich, 98%), à raison d'une concentration de 20 µm, ladite solution étant préparée à partir d'une eau ultrapure (Sartorius, Germany) préalablement désaérée afin de prévenir l'oxydation du groupe thiol. De cette étape d'immersion résulte la formation à la surface de l'électrode d'une monocouche autoassemblée de 4-mercaptopyridine.

L'électrode ainsi traitée est ensuite rincée soigneusement avec de l'eau puis l'électrode est de nouveau immergée sans contrôle de potentiel dans une solution comprenant 0,1 mM de K₂PtCl₄ (Aldrich, 99,99%) et 0,1 M de H₂SO₄ (Merck, ultrapure), de sorte à ce que les ions Pt s'adsorbent et se complexent sur la monocouche autoassemblée. Après un nouveau rinçage à l'eau, l'électrode est ensuite transférée dans une cellule électrochimique, contenant uniquement 0,1 M de H₂SO₄ et soumise à un balayage de potentiel de sorte à ce que les ions Pt complexés soient électroréduits pour former des particules métalliques de platine.

## Revendications

1. Procédé d'élaboration d'une couche à stockage de charges comprenant des particules métalliques d'une cellule de mémoire, ladite couche consistant en une couche organique comprenant, en surface, lesdites particules métalliques, ledit procédé comprenant les étapes suivantes :
- une étape de greffage d'un substrat métallique, semiconducteur ou électriquement isolant par une couche organique comprenant en surface des groupes aptes à complexer au moins un élément métallique sous forme cationique ;
- une étape de mise en contact de ladite couche avec une solution comprenant ledit élément métallique sous forme cationique, moyennant quoi ledit élément métallique est complexé par lesdits groupes susmentionnés ; et
- une étape de réduction dudit élément métallique complexé en élément métallique à l'état d'oxydation 0, moyennant quoi l'on obtient des particules métalliques.

2. Procédé d'élaboration selon la revendication 1, dans lequel la couche organique est une couche organique auto-assemblée.

3. Procédé d'élaboration selon la revendication 1 ou 2, dans lequel l'étape de greffage est obtenue par mise en contact dudit substrat avec au moins un composé comprenant au moins un premier groupe apte à réagir avec un groupe présent en surface dudit substrat pour former une liaison covalente et au moins un second groupe apte à complexer au moins un élément métallique, ledit premier groupe et ledit second groupe étant éventuellement séparés par une chaîne hydrocarbonée ayant un nombre d'atomes de carbone supérieur ou égal à 1.

4. Procédé d'élaboration selon la revendication 3, dans lequel le second groupe apte à complexer un élément métallique est un groupe comprenant un atome porteur d'un doublet libre et/ou d'une charge négative.

5. Procédé d'élaboration selon la revendication 3 ou 4, dans lequel le composé répond à l'une des formules suivantes :
R-(CH₂)ₙ-SiX₃
dans laquelle :
- les X représentent les groupes aptes à se greffer, éventuellement après hydrolyse, à la surface du substrat, ces groupes étant choisis, indépendamment parmi les atomes d'halogène, les groupes alcoxy ;
- R est choisi parmi les groupes amine, carboxyle, thiol, -OH ;
- n est un nombre entier supérieur ou égal à 1 ;
R-X¹
dans laquelle :
- R est choisi parmi les groupes amine, carboxyle, thiol, -OH ;
- X¹ est Li, MgX², X² étant un atome d'halogène ;
R-OH
dans laquelle R est choisi parmi les groupes amine, carboxyle, thiol, -OH.

6. Procédé d'élaboration selon l'une quelconque des revendications 3 à 5, comprenant en outre, avant l'étape de greffage, une étape de traitement dudit substrat, de sorte à créer à sa surface des groupes réactifs qui seront susceptibles de réagir avec les premiers groupes du composé tel que défini aux revendications 3 à 5.

7. Procédé selon l'une quelconque des revendications précédentes, dans lequel la solution est une solution comprenant des cations métalliques choisis parmi les cations de platine, palladium, ruthénium, cobalt, nickel et les mélanges de ceux-ci.

8. Procédé selon l'une quelconque des revendications précédentes, dans lequel l'étape de réduction est réalisée en appliquant au substrat immergé dans un électrolyte un potentiel d'électrode suffisant pour obtenir ladite réduction.

9. Procédé selon l'une quelconque des revendications 1 à 7, dans lequel l'étape de réduction est réalisée par mise en contact du substrat immergé dans un électrolyte avec un agent réducteur.

10. Couche à stockage de charges surmontant un substrat métallique, semi-conducteur ou électriquement isolant d'une cellule de mémoire susceptible d'être obtenu par le procédé tel que défini aux revendications 1 à 9, ladite couche consistant en une couche organique greffée sur ledit substrat et comprenant, à sa surface, des particules métalliques.

11. Cellule de mémoire comprenant au moins une couche à stockage de charges surmontant un substrat métallique, semi-conducteur ou électriquement isolant telle que définie à la revendication 10, cette cellule de mémoire pouvant être une cellule mémoire de type capacitive ou résistive.
